# EUROPEAN PATENT APPLICATION

(11) **EP 1 313 142 A2**
(43) Date of publication of application: **21.05.2003**
(21) Application number: 02257723.3
(22) Date of filing: 07.11.2002
(51) Int. Cl.: H01L 23/485

(54) **Method of manufacturing a rerouting layer on a semiconductor device and corresponding semiconductor device**

(30) Priority: 09.11.2001 JP 2001345208
(71) Applicant: SHINKO ELECTRIC INDUSTRIES CO. LTD., Nagano-shi, Nagano 380-0921 (JP)
(72) Inventor: Ito, Daisuke, Oaza Kurita, Nagano-shi, Nagano,380-0921 (JP); Kazama, Takuya, Oaza Kurita, Nagano-shi, Nagano,380-0921 (JP)
(74) Representative: Fenlon, Christine Lesley

(57) **Abstract**

In a semiconductor device manufacturing method embodying the present invention for forming a rerouting layer (30), which has wirings (29) for electrically leading electrode terminals (23) and bonding pads (28), on a major surface side (20a) on which the electrode terminals (23) of a semiconductor element (20) are provided, the wirings (29) are formed thinner than the bonding pads (28).

## Description

The present invention relates to a semiconductor device manufacturing method and a semiconductor device. More particularly, the present invention relates to the technology that is useful for miniaturization of a rerouting layer formed on a semiconductor element.

In order to mount a semiconductor element on a wiring substrate such as an interposer, or the like, there are several methods. Focusing only on electrical connecting methods, there is the method of electrically connecting the interposer and the semiconductor element by wire bonding. According to this method, positional alignment between each of the bonding pads of the interposer and the semiconductor element must be established.

By establishing the positional alignment, it is meant that the corresponding pads, i.e., a pair of pads to which both ends of the bonding pad are connected, are arranged in a predetermined positional relationship. Unless this positional alignment is established, respective bonding pads between the interposer and the semiconductor element are arranged irregularly and thus the wire bonding cannot be desirably conducted. Even when the wire bonding can be conducted, the bonding wires mingle irregularly with each other and, thus, such bonding wires are undesirable in design.

Therefore, in order to achieve the positional alignment, rerouting technology is applied to the semiconductor element in some cases. Rerouting technology means such a method in which further work is applied to the semiconductor element, which has already been manufactured by a manufacturer, in order to lead the wirings from electrode terminals built in the semiconductor element and to provide the bonding pads onto the wirings.

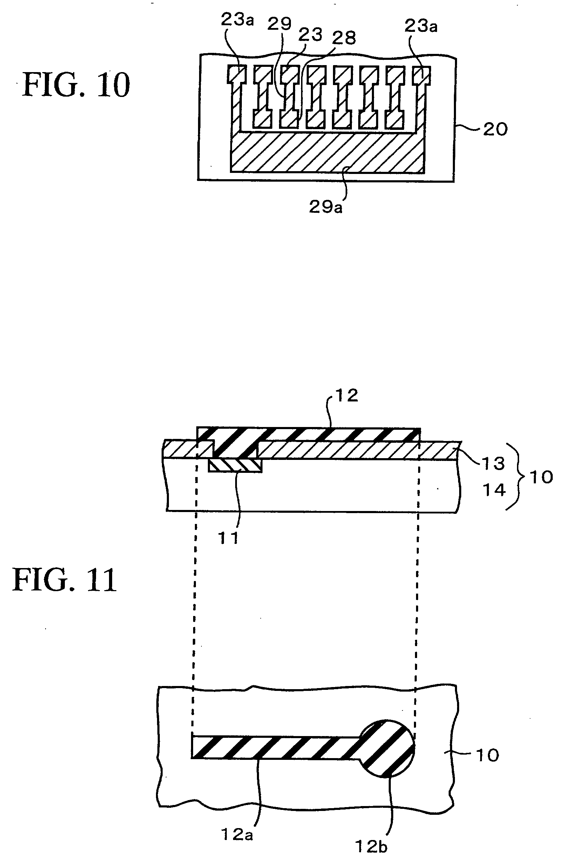

An example of previously-proposed rerouting technology is shown in FIG.11 of the accompanying drawings. FIG.11 is a sectional view showing an example of previously-proposed rerouting technology and a plan view of the same.

In FIG.11, a reference 10 denotes a semiconductor element. Also, a reference 13 denotes a passivation layer that protects a circuit-formed surface of a silicon substrate 14. An opening is formed in the passivation layer 13, and an electrode terminal 11 is positioned on a bottom portion of the opening. The electrode terminal 11 is a power supply terminal used to supply power to a circuit, or a signal terminal used to input/output a signal into/from the circuit.

The structure explained up to now is manufactured by the manufacturer of the semiconductor element.

In addition to this structure, a rerouting layer 12 is incorporated by the rerouting technology. As shown in a plan view of FIG.11, the rerouting layer 12 consists of a wiring 12a and a bonding pad 12b. The wiring 12a is needed to arrange the bonding pad 12b in a different position from the electrode terminal 11. In this manner, the positional alignment between the bonding pad 12b and a bonding pad (not shown) of the interposer can be established.

Meanwhile, ultrasonic wave, heat, pressure, or the like is applied to the bonding pad 12b during the wire bonding. In order to protect the circuit from these external impacts, the bonding pad 12b must be formed to have a thick film thickness.

In a previously-proposed case, the wiring 12a and the bonding pad 12b are not particularly distinguished and are formed integrally in the same step at the same time. As a result, a thickness of the wiring 12a becomes equal to a thickness of the bonding pad 12b, which has thick film thickness, and thus the wiring 12a is also formed to have a thick film thickness.

However, if the wiring 12a has such thick film thickness, it cannot be finely patterned. This is because, when the wiring 12a is to be formed by wet etching, it takes much time to etch the wiring 12a owing to its thick film thickness, and then the etching proceeds in the lateral direction due to this excess time, which makes the etching precision worse.

In a previously-proposed case, the typical film thickness of the wiring 12a is identical to the bonding pad 12b and is about 8 µm, which poses a limit on L/S of about 30/30 µm. The L/S means a ratio of a width of the wiring (Line) to an interval (Space) between neighboring wirings.

The above fact becomes an obstacle to the miniaturization of a type of semiconductor device, which has been required in recent years.

Accordingly, it is desirable to provide a semiconductor device manufacturing method capable of miniaturizing a rerouting layer on a semiconductor element, and a semiconductor device.

According to an embodiment of a first aspect of the present invention, there is provided a semiconductor device manufacturing method, for forming a rerouting layer, which has wirings for electrically leading out electrode terminals and bonding pads, on a major surface on which the electrode terminals of a semiconductor element are provided, wherein the wirings are formed thinner than the bonding pads.

In this embodiment, since the wirings of the rerouting layer are thinner than the bonding pads, the patterning precision of the wirings can be improved and, thus, the fine wirings can be formed.

In order to form the wirings to have the thin thickness as above, the following steps (a) to (c) may be executed according to an embodiment of a second aspect of the present invention.
(a) Forming a first conductive layer, which is electrically connected to the electrode terminals, on the major surface of the semiconductor element.
(b) Forming a second conductive layer on portions of the first conductive layer, which portions act as the bonding pads.
(c) Forming the wirings, which are made of the first conductive layer, and the bonding pads, which are made by laminating the first conductive layer and the second conductive layer, by patterning the first conductive layer.
   Alternatively, the following steps (d) to (f) may be executed according to an embodiment of a third aspect of the present invention.
(d) Forming a first conductive layer, which is electrically connected to the electrode terminals, on the major surface of the semiconductor element.
(e) Forming the wirings, which are made of the first conductive layer, by patterning the first conductive layer while leaving portions of the first conductive layer, which portions act as the bonding pads.
(f) Forming the bonding pads, which are made by laminating the first conductive layer and a second conductive layer, by forming the second conductive layer on the portions of the first conductive layer.
   In embodiments of the first and second aspects of the present invention, the wirings are formed by patterning the first conductive layer only, while forming the bonding pads by using the laminated films consisting of the first and second conductive layers to have a thick film thickness. Since wiring portions of the first conductive layer are not formed thick, the patterning precision of the wirings can be improved and thus the fine wirings can be formed.
   Alternatively, the following steps (g) to (j) may be executed according to an embodiment of a fourth aspect of the present invention.
(g) Forming a masking layer having openings, which have same shapes as the wirings and the bonding pads, on the major surface of the semiconductor element.
(h) Forming a first conductive layer, which is electrically connected to the electrode terminals, in at least the openings of the masking layer.
(i) Patterning the first conductive layer by removing the masking layer.
(j) Forming the bonding pads, which are made by laminating the first conductive layer and a second conductive layer, by forming the second conductive layer on portions of the first conductive layer, which portions act as the bonding pads, after the masking layer is removed.
   Alternatively, the following steps (k) to (n) may be executed according to an embodiment of a fifth aspect of the present invention.
(k) Forming a masking layer having openings, which have same shapes as the wirings and the bonding pads, on the major surface of the semiconductor element.
(l) Forming a first conductive layer, which is electrically connected to the electrode terminals, in at least the openings of the masking layer.
(m) Forming a second conductive layer on portions of the first conductive layer, which portions act as the bonding pads.
(n) Forming the bonding pads, which are made by laminating the first conductive layer and the second conductive layer, by patterning the first conductive layer by removing the masking layer after the second conductive layer is formed.

In embodiments of the fourth and fifth aspects of the present invention, the first conductive layer is formed in the opening of the masking layer and then the first conductive layer is patterned by removing this masking layer. Since the bonding pads are formed by the first and second conductive layers to have a thick film thickness, but the wiring portions of the first conductive layer are not formed to have a thick film thickness, the patterning precision of the wirings can be improved and thus the fine wirings can be formed.

Also, in an embodiment of any one of the second to fifth aspects of the present invention, the step of forming the first conductive layer may be executed by sputtering.

The sputtering is preferable to form the first conductive layer having a thin film thickness.

Also, in an embodiment of any one of the second to fifth aspects of the present invention, the sputtering may be carried out by sputtering titanium (Ti), or chromium (Cr), and then sputtering copper (Cu).

Also, in the above embodiment of the present invention, as the semiconductor element, an element in which an insulating layer made of silicon nitride (SiN), or polyimide, is formed on portions except the electrode terminals on the major surface may be employed.

The silicon nitride and the polyimide have good affinity to titanium (Ti) and chromium (Cr). Hence, separation of the first conductive layer, under which titanium (Ti) or chromium (Cr) is formed as the underlying layer, from the insulating layer made of silicon nitride or polyimide, can be suppressed.

Also, in an embodiment of the present invention, the step of forming the second conductive layer may be carried out by laminating a plurality of metal layers, and an uppermost layer of the laminated films of the metal layers may be formed of gold (Au) or palladium (Pd).

Since the uppermost layer is formed of gold (Au), the jointing force to the bonding wire made of gold can be enhanced. Even when gold (Au) is used in this way, the second metal layer using this gold (Au) is formed only on the portions that act as the bonding pads, so the expensive gold (Au) is not wasted excessively.

Also, in this embodiment of the present invention, as the laminated films of the metal layers, any one of copper (Cu)/nickel (Ni)/gold (Au) layers, titanium-tungsten (TiW)/gold (Au) layers, or nickel (Ni)/palladium (Pd) layers may be employed.

Forming the copper (Cu) layer in the copper (Cu)/nickel (Ni)/gold (Au) layers to have a thick film thickness can protect the underlying circuit from the external impact applied during the wire bonding process.

Also, the titanium-tungsten (TiW) layer in the titanium-tungsten (TiW)/gold (Au) layers has the advantage that such a layer is difficult to corrode in the environment and has a high mechanical strength in contrast to the copper (Cu) layer. Because of the high mechanical strength, the bonding property is not deteriorated if such a layer is formed to have a thin film thickness.

Also, according to an embodiment of a sixth aspect of the present invention, there is provided a semiconductor device that is manufactured by a semiconductor device manufacturing method embodying the present invention.

In an embodiment of the sixth aspect of the present invention, the semiconductor element is adhered to a wiring substrate, and the bonding pads of the rerouting layer on the semiconductor element and bonding pads of the wiring substrate are wire-bonded.

In a semiconductor device embodying the present invention, since positional alignment between the bonding pads of the rerouting layer on the semiconductor element and bonding pads of the wiring substrate can be established, the wire bonding can be carried out desirably.

In another embodiment of the sixth aspect of the present invention, there is provided a semiconductor device in which another semiconductor element is stacked on the semiconductor element, and the electrode terminals of another semiconductor element are electrically connected to the rerouting layer.

A semiconductor device embodying the present invention is the so-called stacked semiconductor device.

Also, in an embodiment of a seventh aspect of the present invention, there is provided a semiconductor device in which a rerouting layer having wirings, which electrically lead out electrode terminals, and bonding pads is provided on the major surface on which the electrode terminals of the semiconductor element are provided, and the wirings are formed thinner than the bonding pads.

Reference will now be made, by way of example, to the accompanying drawings, in which:
FIGS.1A to 1H are sectional views to explain a semiconductor device manufacturing method according to a first embodiment of the present invention;
FIGS.2A to 2G are sectional views to explain a semiconductor device manufacturing method according to a second embodiment of the present invention;
FIGS.3A to 3E are sectional views to explain a semiconductor device manufacturing method according to a third embodiment of the present invention;
FIGS.4A to 4G are sectional views to explain a semiconductor device manufacturing method according to a fourth embodiment of the present invention;
FIG.5 is a sectional view showing a semiconductor device according to a fifth embodiment of the present invention;
FIG.6 is a plan view showing the case where lengths of wirings are not equalized;
FIG.7 is a plan view showing the case where lengths of wirings are equalized by applying an embodiment of the present invention;
FIG.8 is a plan view showing two types of semiconductor elements between which no pin compatibility is provided;
FIG.9 is a plan view showing the case where pin compatibility is provided between two types of semiconductor elements by applying an embodiment of the present invention to one of these semiconductor elements;
FIG.10 is a plan view showing the case where a power supply line of a rerouting layer is fully planarized by applying an embodiment of the present invention; and
FIG.11 (described above) is a sectional view and a plan view showing an example of previously-proposed rerouting technology.

Next, preferred embodiments of the present invention will be explained in detail with reference to the accompanying drawings hereinafter.

### (1) First Embodiment

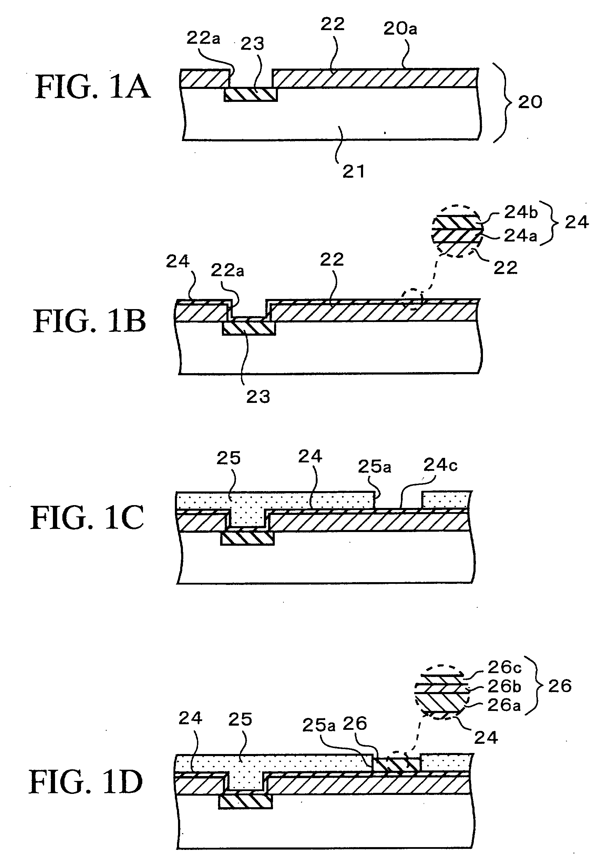

A semiconductor device manufacturing method according to a first embodiment of the present invention will be explained with reference to FIGS.1A to 1H hereunder.

In this embodiment, first a semiconductor element 20 shown in FIG.1A is prepared. In-FIG.1A, 23 is an electrode terminal provided to a major surface 20a of the semiconductor element 20. Although not particularly illustrated, the electrode terminal 23 is electrically connected to a circuit of a silicon substrate 21.

A function of the electrode terminal 23 is not limited. The electrode terminal 23 may be used as either the terminal for inputting/outputting a signal into/from the circuit, or the terminal for supplying power to the circuit. The circuit is protected by a passivation layer (insulating layer) 22. Material of the passivation layer 22 is not limited, but SiN (silicon nitride) or polyimide is preferable. An opening 22a is formed in the passivation layer 22, and the electrode terminal 23 is exposed from the opening 22a.

Then, as shown in FIG.1B, a Cr/Cu layer (first conductive layer) 24 is formed. The Cr/Cu layer is a laminated film that is formed by laminating a chromium (Cr) layer 24a and a copper (Cu) layer 24b in this order (see in an inside of a dotted-line circle). Portions, on which this Cr/Cu layer 24 is formed, are an upper surface of the passivation layer 22, an upper surface of the electrode terminal 23, and side walls of the opening 22a. Since the Cr/Cu layer 24 is formed on the electrode terminal 23, the Cr/Cu layer 24 and the electrode terminal 23 are electrically connected to each other.

Since this Cr/Cu layer 24 is used as the wiring later, such Cr/Cu layer 24 should be formed as thin as possible to increase the patterning precision. In order to reduce a film thickness, it is preferable that the chromium layer 24a and the copper layer 24b be formed by the sputtering. In the present embodiment, a total film thickness of the Cr/Cu layer 24 is about 0.5 to 1 µm. This value is considerably smaller than the value (about 8 µm) in a previously-proposed case.

Also, since chromium (Cr) in the Cr/Cu layer 24 has good affinity to SiN (silicon nitride) and polyimide of the passivation layer 22, such an advantage can be obtained that the Cr/Cu layer 24 is hard to peel off from the passivation layer 22. Since titanium (Ti) has also the same merit, a Ti/Cu layer may be employed in place of the Cr/Cu layer 24. This Ti/Cu layer means a laminated film that is formed by laminating a titanium (Ti) layer and a copper (Cu) layer in this order. This Ti/Cu layer is also suitable for the sputtering.

Then, as shown in FIG.1C, a photoresist layer 25 is formed on the Cr/Cu layer 24. Then, an opening 25a is formed by exposing/developing the photoresist layer 25. This opening 25a corresponds to a portion 24c on which the bonding pad is formed later.

Then, as shown in FIG.1D, a Cu/Ni/Au layer (second conductive layer) 26 is formed selectively only in the opening 25a. This Cu/Ni/Au layer 26 means a laminated film that is formed by laminating a copper (Cu) layer 26a, a nickel (Ni) layer 26b, and a gold (Au) layer 26c in this order (see an inside of a dotted-line circle). Each layer is formed by electrolytic plating while using the Cr/Cu layer 24 as a power feeding layer. A total film thickness of the Cu/Ni/Au layer 26 is less than about 1 µm.

The opening 25a corresponds to a portion that acts as the bonding pad later. By. forming Cu/Ni/Au layer 26 only in the opening 25a as above, a thickness necessary for the bonding pad can be obtained. Furthermore, the Cr/Cu layer 24 formed at a portion, which is covered with the photoresist layer 25 and is used as the wiring later, remains to have a thin thickness. In this manner, the wiring and the bonding pad are formed separately in an embodiment of the present invention, which is clearly different from a previously-proposed case where the wiring and bonding pad, without being distinguished, are formed integrally.

Each layer of this Cu/Ni/Au layer 26 has its proper role respectively. For example, the lowermost copper layer 26a is a layer that is formed to have a thick film thickness in order to obtain the film thickness necessary for the bonding pad. Being formed thick in this manner, the bonding pad can protect an underlying circuit from the external impact applied when the wire bonding is performed. Also, the uppermost gold layer 26c is a layer that increases an adhering force to the bonding wire made of gold. Then, the nickel layer 26b is a diffusion preventing layer that prevents diffusion of gold in the gold layer 26c into the copper layer 26a.

Also, a TiW/Au layer may be employed in place of the Cu/Ni/Au layer 26. This TiW/Au layer means a laminated film that is formed by laminating a titanium-tungsten (TiW) layer and a gold (Au) layer in this order. In contrast to the copper (Cu), there are such merits that ① TiW is difficult to corrode in a variety of environments and ② TiW has a high mechanical strength. Since TiW has the high mechanical strength, the bonding characteristic is hardly deteriorated even when the TiW layer is formed thin.

In each case that the Cu/Ni/Au layer 26 or the TiW/Au layer is formed, such layer is formed only in the opening 25a and is not formed on an overall surface of the Cr/Cu layer 24. Therefore, there is no need to waste the expensive gold (Au).

It should be noted that a Ni/Pd layer may be employed in place of the TiW/Au layer. This Ni/Pd layer means a laminated film that is formed by laminating nickel (Ni) and palladium (Pd) in this order.

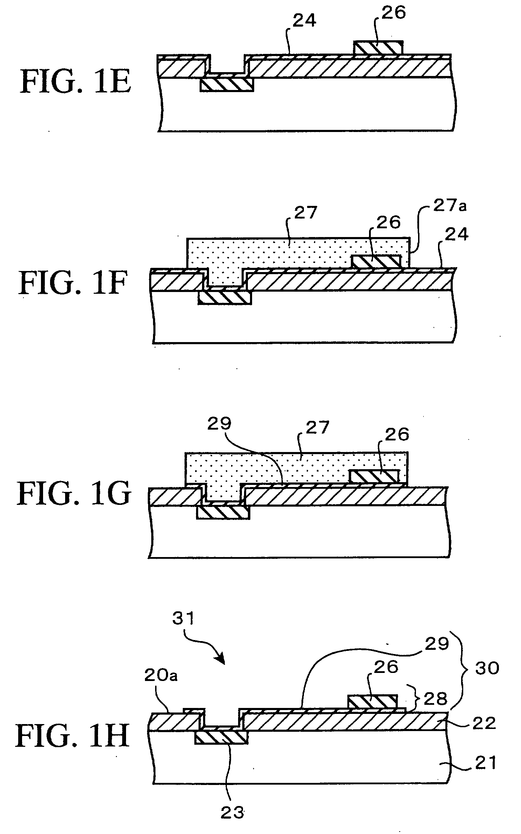

After the Cu/Ni/Au layer 26 is formed as above, the step in FIG.1E is executed. In this step, the photoresist layer 25 is removed and the Cu/Ni/Au layer 26 is left on the Cr/Cu layer 24.

Then, as shown in FIG.1F, a photoresist layer 27 that is different from the above photoresist layer 25 is formed. Portions on which this photoresist layer 27 is formed are an upper surface of the Cr/Cu layer (first conductive layer) 24 and upper and side surfaces of the Cu/Ni/Au layer (second conductive layer) 26. An opening 27a is formed by exposing/ developing the photoresist layer 27. This opening 27a is formed on the portion of the Cr/Cu layer 24, which does not act as the wiring, for example.

Then, as shown in FIG.1G, the Cr/Cu layer 24 is selectively wet-etched to be patterned, while using the photoresist 27 as a mask of subtractive method.

In the etching, since the Cr/Cu layer 24 has a thin thickness (about 0.5 to 1 µm) and is not formed as the thick film, the etching precision can be much improved compared to a previously-proposed case, and thus a fine wiring 29 can be formed. Specifically, L/S of the wiring 29 can be set to about 10/10 µm and thus significantly finer wiring can be formed in contrast to 30/30 µm in a previously-proposed case. This fact can largely contribute to the miniaturization of a semiconductor device, which has been requested in recent years. The photoresist layer 27 is removed after the wiring 29 is formed.

According to these steps, as shown in FIG.1H, a rerouting layer 30 having a bonding pad 28, which is formed by laminating the Cr/Cu layer 24 and the Cu/Ni/Au layer 26, and the wiring 29, is completed. Thus, a semiconductor device 31 according to the present embodiment is completed.

As described above, in the present embodiment, each forming steps of the wiring 29 and the bonding pad 28 are separated from each other, and thus the wiring 29 is formed to have a thin thickness. Therefore, the wiring 29 can be formed more finely than in a previously-proposed case.

### (2) Second Embodiment

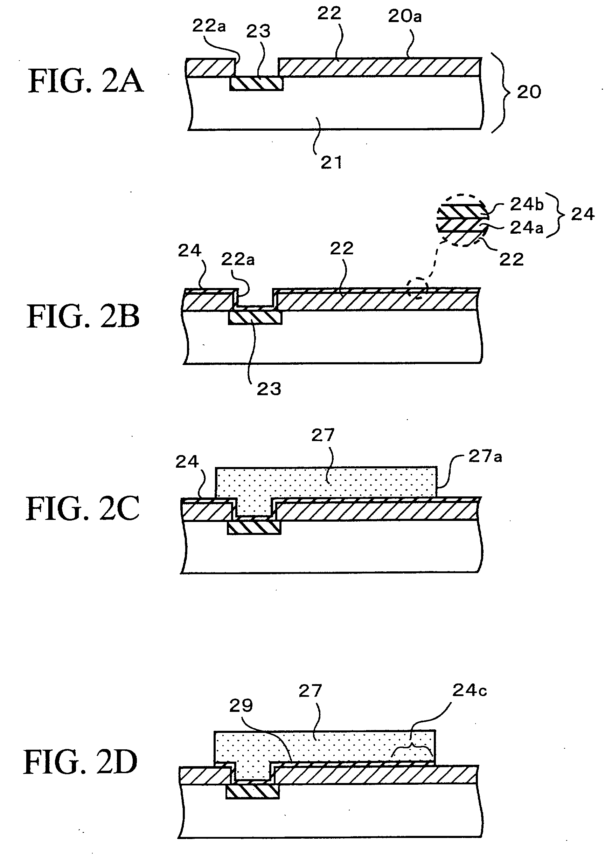

Next, a semiconductor device manufacturing method according to a second embodiment of the present invention will be explained with reference to FIGS.2A to 2G hereunder. In these figures, the same symbols are affixed to the same member as those that have already been explained above, and their explanation will be omitted in the following.

In the first embodiment, the step of forming the Cu/Ni/Au layer (second conductive layer) 26 is executed (FIG.1D) and then the Cr/Cu layer (first conductive layer) 24 is patterned to form the wiring 29 (FIG.1G). In contrast, in the present embodiment, the order of these steps is reversed.

First, the semiconductor element 20 shown in FIG.2A is prepared. This semiconductor element 20 is the same as explained in the first embodiment.

Then, as shown in FIG.2B, the Cr/Cu layer (first conductive layer) 24 is formed by the sputtering. A total film thickness of the Cr/Cu layer 24 is thin such as about 0.5 to 1 µm, like the first embodiment. Also, the Cr/Cu layer 24 forming portion and the function are similar to those explained in the first embodiment.

The steps in FIGS.2A and 2B are similar to the steps in FIGS.1A and 1B. However, the following steps are different from those in the first embodiment.

As shown in FIG.2C, the photoresist layer 27 is formed on the Cr/Cu layer (first conductive layer) 24. The opening 27a is formed in the photoresist layer 27 by exposing/developing this photoresist layer 27. This opening 27a is formed on the portion of the Cr/Cu layer 24, which does not act as the wiring, for example.

Then, as shown in FIG.2D, the Cr/Cu layer 24 is selectively wet-etched to be patterned, while using the photoresist layer 27 as an etching mask of the subtractive method.

According to this etching, while leaving the portion 24c of the Cr/Cu layer 24, which is used as the bonding pad, the wiring 29 made of the Cr/Cu layer can be formed. In this patterning, since the Cr/Cu layer 24 is not formed as the thick film like in a previously-proposed case, and has a thin thickness of about 0.5 to 1 µm, the patterning precision can be much improved compared to a previously-proposed case, and thus the fine wiring 29 can be formed.

The photoresist layer 27 is removed after this wiring 29 is formed.

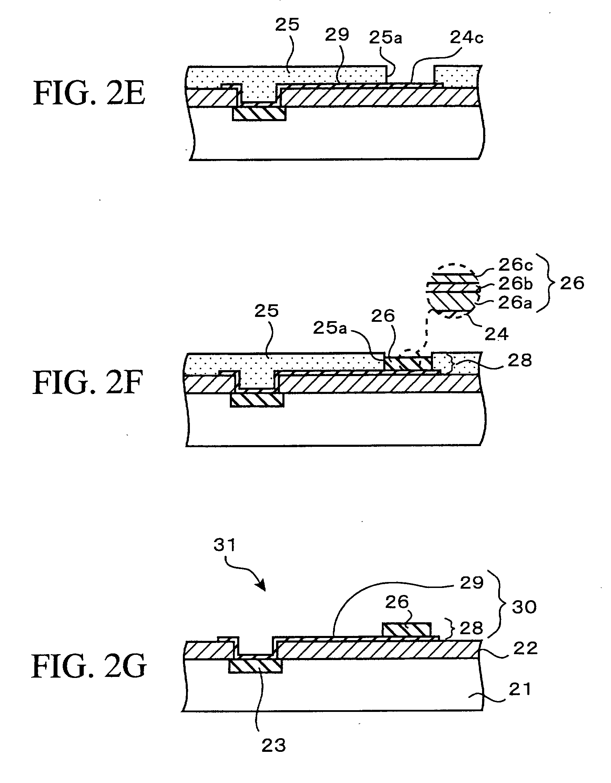

Then, as shown in FIG.2E, the photoresist layer 25 different from the above photoresist layer is formed on the wiring 29. Then, the opening 25a is formed by exposing/ developing the photoresist layer 25. This opening 25a corresponds to the portion 24c on which the bonding pad is formed later.

Then, as shown in FIG.2F, the Cu/Ni/Au layer (second conductive layer) 26 is selectively formed only in the opening 25a. Accordingly, the bonding pad 28 formed by laminating the Cr/Cu layer 24 and the Cu/Ni/Au layer 26 is formed.

In this case, a total film thickness of the Cu/Ni/Au layer 26 is less than about 1 µm, like the first embodiment. Also, the forming method and functions of respective layers in the Cu/Ni/Au layer 26 are similar to those in the first embodiment, and also the TiW/Au layer or the Ni/Pd layer may be employed instead of the Cu/Ni/Au layer 26, like the first embodiment.

Then, as shown in FIG.2G, the photoresist layer 25 is. removed. Accordingly, the rerouting layer 30 having the bonding pad 28 and the wiring 29 is completed. Thus, a semiconductor device 31 according to the present embodiment is completed.

As described above, in the present embodiment, first the Cr/Cu layer (first conductive layer) 24 is formed to have a thin film thickness, and then the fine wiring 29 is formed by patterning the Cr/Cu layer 24. Then, the bonding pad 28 having a thick film thickness is formed after the fine wiring 29 is formed. In this manner, since each forming steps of the wiring 29 and the bonding pad 28 are separated from each other, the wiring 29 that is finer than in a previously-proposed case can be formed.

### (3) Third Embodiment

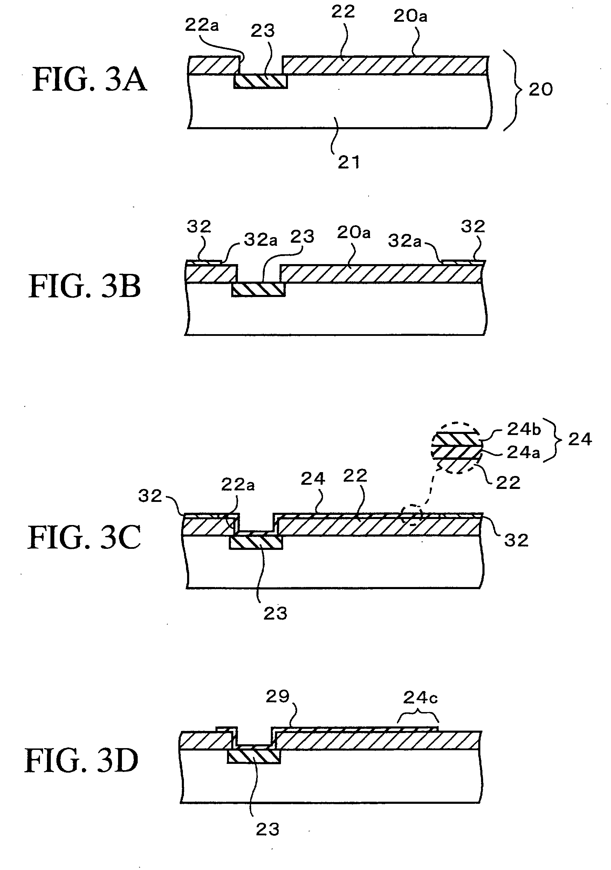

Next, a semiconductor device manufacturing method according to a third embodiment of the present invention will be explained with reference to FIGS.3A to 3E hereunder. In these figures, the same symbols are affixed to the same member as those that have already been explained above, and their explanation will be omitted in the following.

In the first and second embodiments, the wiring 29 is formed by the subtractive method (see FIG.1G and FIG.2D). In contrast, in the present embodiment, the wiring 29 is formed by the lift-off method.

First, the semiconductor element 20 shown in FIG.3A is prepared. This semiconductor element 20 is similar to that explained in the first embodiment.

Then, as shown in FIG.3B, a photoresist layer (masking layer) 32 is formed on the major surface 20a of the semiconductor element 20. Then, an opening 32a having a shape that is identical to the wiring and the bonding pad of the rerouting layer (described later) is formed by exposing/developing the photoresist layer 32.

Then, as shown in FIG.3C, the Cr/Cu layer (first conductive layer) 24 is formed by the sputtering. The portions, on which this Cr/Cu layer 24 is formed, are an upper surface of the passivation layer 22 exposed in the opening 32a, side walls of the opening 22a, and an upper surface of the electrode terminal 23 exposed in the opening 22a. The Cr/Cu layer 24 may not be formed on other portions. A total film thickness of this Cr/Cu layer 24 is about 0.5 to 1 µm.

Then, as shown in FIG.3D, the Cr/Cu layer 24 is patterned by removing the photoresist layer 32 (lift-off method). Accordingly, the portion used as the bonding pad and the wiring 29 later are formed in the Cr/Cu layer 24. According to this step, since the Cr/Cu layer 24 is not formed as a thick film, unlike a previously-proposed case, and is lifted off in the thin film state, the Cr/Cu layer 24 can be patterned with good precision and thus the fine wiring 29 can be formed.

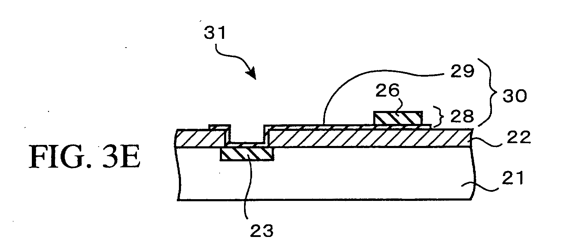

After this, the totally same steps as those described in FIGS.2E to 2G are carried out. Accordingly, as shown in FIG.3E, the rerouting layer 30 having the wiring 29 and the bonding pad 28 is completed. Thus, a semiconductor element 31 according to the present embodiment is completed.

In the present embodiment, each forming steps of the wiring 29 and the bonding pad 28 are separated from each other, and the Cr/Cu layer 24 is not patterned in the state of thick film, unlike a previously-proposed case, but is patterned in the state of the thin film. Thus, the wiring 29 can be formed finely.

### (4) Fourth Embodiment

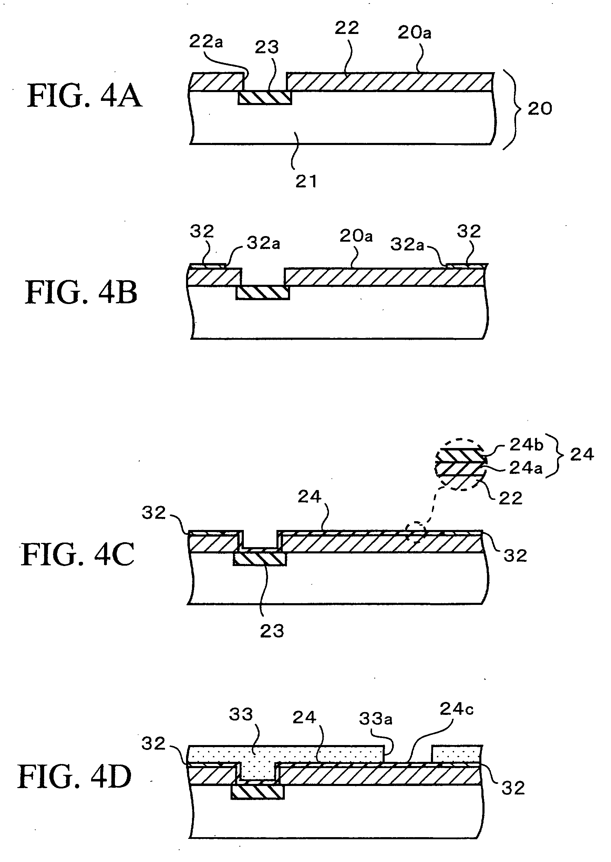

Next, a semiconductor device manufacturing method according to a fourth embodiment of the present invention will be explained with reference to FIGS.4A to 4G hereunder. In these figures, the same symbols are affixed to the same member as those that have already been explained above, and their explanation will be omitted in the following.

In the present embodiment, the wiring is formed by the lift-off method, like the third embodiment.

First, the semiconductor element 20 shown in FIG.4A is prepared. This semiconductor element 20 is similar to that explained in the first embodiment.

Then, as shown in FIG.4B, the photoresist layer (masking layer) 32 is formed on the major surface 20a of the semiconductor element 20. Then, the opening 32a having the shape that is identical to the wiring and the bonding pad of the rerouting layer (described later) is formed by exposing/developing the photoresist layer 32.

Then, as shown in FIG.4C, the Cr/Cu layer (first conductive layer) 24 is formed by the sputtering. A total film thickness of this Cr/Cu layer 24 is about 0.5 to 1 µm and is small.

Since the steps in FIGS.4A to 4C are similar to the steps in FIGS.3A to 3C in the third embodiment, they will not be explained in detail. See the third embodiment if necessary.

The following steps are different from the third embodiment.

Namely, as shown in FIG.4D, the photoresist layer 32 is not removed as in the third embodiment, but another photoresist layer 33 is formed on the Cr/Cu layer 24. Then, an opening 33a is formed by exposing/developing this photoresist layer 33. Such opening 33a corresponds to the portion of the Cr/Cu layer 24, on which the bonding pad is formed later.

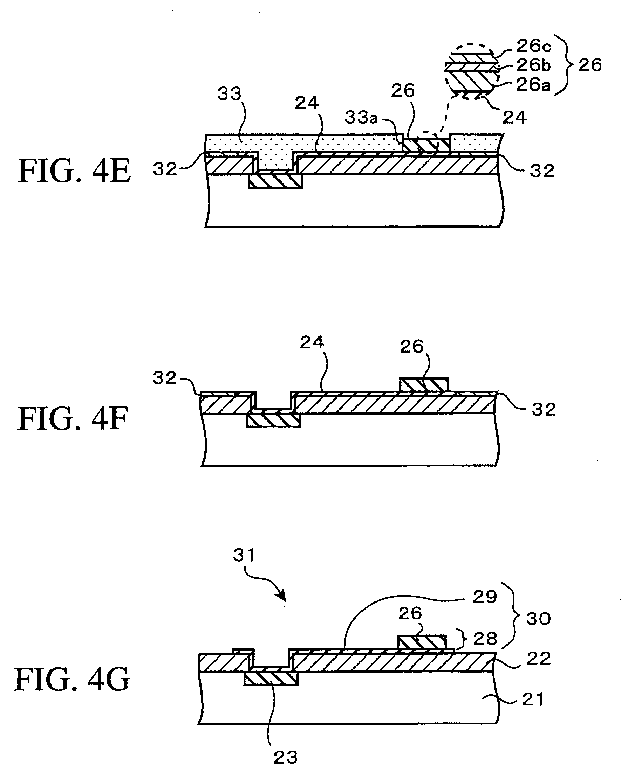

Then, as shown in FIG.4E, the Cu/Ni/Au layer (second conductive layer) 26 is formed selectively only in the opening 33a. Each layer of the Cu/Ni/Au layer 26 is formed by electrolytic plating while using the Cr/Cu layer 24 as the power feeding layer.

In this case, a total film thickness of the Cu/Ni/Au layer 26 is set to less than about 1 µm, like the above embodiments. Also, the forming method and functions of respective layers in the Cu/Ni/Au layer 26 are similar to those in the first embodiment, and also the TiW/Au layer or the Ni/Pd layer may be employed instead of the Cu/Ni/Au layer 26, like the above embodiments.

Then, as shown in FIG.4F, the photoresist layer 33 is removed.

Then, as shown in FIG.4G, the Cr/Cu layer 24 is patterned by removing the photoresist layer 32 (lift-off method). Accordingly, the rerouting layer 30 having the bonding pad 28, which is formed by laminating the Cr/Cu layer 24 and the Cu/Ni/Au layer 26, and the wiring 29 is completed. Thus, a semiconductor element 31 according to the present embodiment is completed.

In the present embodiment, only the film thickness of the portion that acts as the bonding pad is increased by the Cu/Ni/Au layer 26, and the Cr/Cu layer 24 on the portion that acts as the wiring 29 can be lifted off in the thin thickness state. Therefore, the wiring 29 can be formed finely.

### (5) Fifth Embodiment

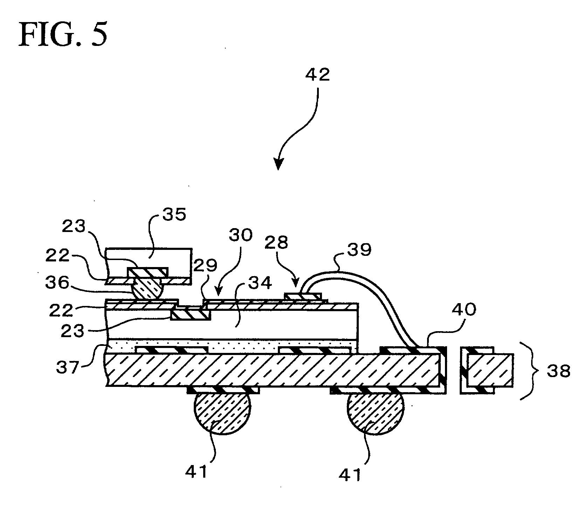

FIG.5 is a sectional view showing a semiconductor device according to a fifth embodiment of the present invention.

In recent years, as shown in FIG.5, a semiconductor device (stacked semiconductor device) 42 that is formed by stacking a plurality of semiconductor elements is employed. An embodiment of the present invention is preferably applied to this type of stacked semiconductor device.

Various types of semiconductor elements are stacked in the stacked semiconductor device. Since a pitch between the electrode terminals is different depending on each semiconductor element, the stacked semiconductor elements are not electrically connected to each other unless the pitch of the electrodes of each semiconductor is converted. The rerouting technology is applied to execute this pitch conversion. Of course, the rerouting technology is needed to attain the positional alignment between the bonding pads of the lowermost semiconductor element and the interposer (wiring substrate).

In FIG.5, a reference numeral 34 denotes a lower semiconductor element, and 35 denotes an upper semiconductor element. Since the pitches between the electrode terminals are different between the semiconductor elements 34 and 35, the pitch conversion is needed. Therefore, the rerouting layer 30 of the semiconductor element 34 is patterned to permit the pitch conversion. Jointing a solder bump 36 of the semiconductor element 35 onto the rerouting layer 30 can electrically connect the semiconductor elements 34 and 35 to each other as desired.

The lower semiconductor element 34 is secured to an interposer (wiring substrate) 38 via an adhesive 37. The type of the interposer 38 is not limited. A rigid wiring substrate or a flexible wiring substrate can be used as the interposer 38. Also, the number of wiring layers is not limited. Either one or multiple wiring layers may be employed.

The electrical connection between the lower semiconductor element 34 and the interposer 38 is carried out by bonding a bonding wire 39 such as a gold wire, or the like to the bonding pads 28, 40.

The rerouting layer 30 is patterned such that positions of respective bonding pads 28, 40 of the semiconductor element 34 and the interposer 38 can be aligned. As a result, it is possible to easily apply the wire bonding to respective bonding pads 28, 40.

In addition, since the wiring 29 becomes fine by applying an embodiment of the present invention to the rerouting layer 30, miniaturization of the overall device can be promoted.

It should be noted that a reference numeral 41 denotes a solder bump 41 (external connection terminal). Reflowing the solder bumps 41 in the state where they rest upon electrode terminals (not shown) of the packaging substrate makes the stacked semiconductor device 42 to be mechanically and electrically connected to the packaging substrate.

The electrical connecting method between the semiconductor elements 34 and 35 is not limited to the above. An embodiment of the present invention can also be applied preferably to a stacked semiconductor device of the type in which the semiconductor elements 34, 35 are electrically connected by the bonding wire in place of the solder bump 36.

Also, the number of the stacked semiconductor elements is not limited to two. The same advantage as the above can be achieved by stacking three or more semiconductor elements.

### (6) Explanation of advantages of the present invention

### (Equalization of wiring length)

As described above, according to an embodiment of the present invention, the fine wiring can be formed. If the wirings become fine, more room is provided and thus the margin in design of the wiring can be increased. Hence, it is possible to execute an equalization of wiring length, which is difficult to achieve in a previously-proposed case.

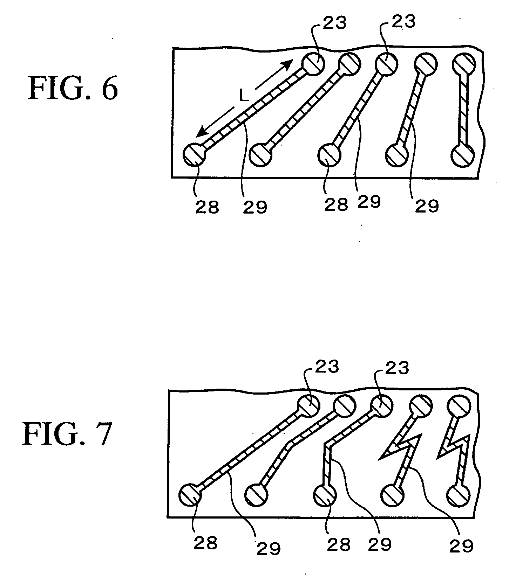

The equalization of wiring length is to make lengths of respective wirings be equal. FIG.6 shows the state in which lengths of respective wirings 29, 29,... are not equalized. In this state, a distance L between the electrode terminal 23 of the semiconductor element and the bonding pad 28 are different for each wiring 29. As a result, such a disadvantage is brought about that a delay time of the signal is varied in each wiring 29.

In contrast, FIG.7 shows the case where the wirings 29 are formed finely by applying an embodiment of the present invention and lengths of respective wirings 29, 29,... are equalized. According to an embodiment of the present invention, since the margin in design of the wiring can be increased, the wirings 29, 29,... can be drawn around relatively freely. Therefore, since the formation of the bent wirings 29, 29,... is made easy, the equalization of the length can easily be carried out. As a result, a semiconductor element with high quality, in which variation in the delay time of the signal is suppressed, can be provided.

### (Pin Compatibility)

The advantage obtained by the miniaturization of the wiring is not only the equalization of the wirings. The miniaturization makes it easy to provide pin compatibility between two semiconductor elements that have no pin compatibility.

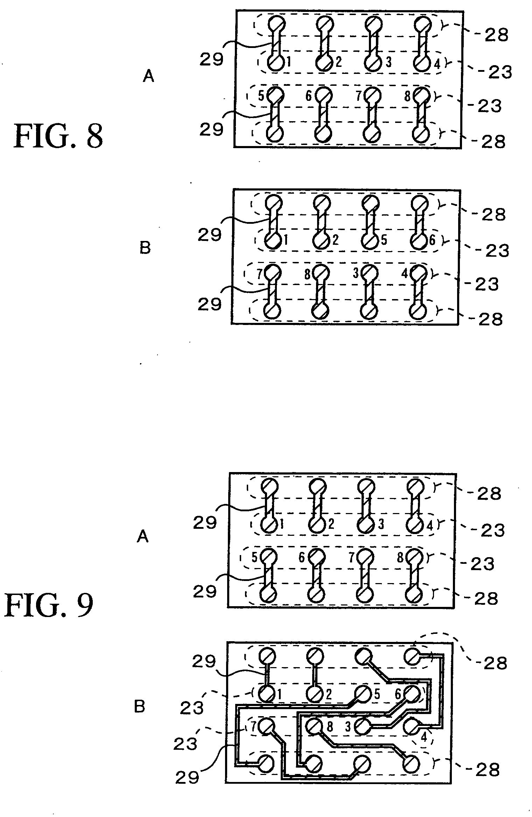

FIG.8 is a plan view showing two types of semiconductor elements A, B between which no pin compatibility is provided.

The semiconductor elements A, B have almost similar electrical characteristics. However, as shown in FIG.8, arrangement of the electrode terminals 23, 23,...(which are distinguished by numerals 1 to 8) is different in the semiconductor elements A, B. Therefore, roles of the bonding pads 28, 28,..., which are formed in the same positions of the semiconductor elements A, B, are different in the semiconductor elements A, B. In such a case, it is said that the semiconductor elements A, B have no pin compatibility.

In contrast, FIG.9 shows the case where pin compatibility is provided between the semiconductor elements A, B by applying an embodiment of the present invention to the semiconductor element B. As shown in FIG.9, in the semiconductor element B, the bonding pads 28, 28,... located in the same positions as the semiconductor element A are rerouted to correspond to the same electrode terminals 23, 23, ... as the semiconductor element A. In this case, it is said that the semiconductor elements A, B have the pin compatibility.

According to an embodiment of the present invention, since the margin in design of the wiring is increased, the above pin compatibility can be easily provided. The pin compatibility offers advantages in following respects.
① Products equivalent to the semiconductor elements manufactured by other companies can be supplied as the second source.
② When a new semiconductor device enters newly into the market in the situation where the existing semiconductor elements occupy the market, or when the existing semiconductor device (the semiconductor element is mounted on the wiring substrate) can be upgraded based on the improvement in performance of the element, remodelling can be implemented without the modification of the wiring substrate.
③ Compatibility with the existing specifications can still be maintained with the progress of generations (miniaturization, capacity, etc.) of the semiconductor element.
④ The responsibility to supply the existing semiconductor elements can be fulfilled.

### (Full planarization of power supply lines)

It is preferable that the power supply line and the ground line of the rerouting layer be formed as a full plane (planar surface). This is because, if these lines are formed as the full plane, not only line impedance, but also ground loop can be reduced, and, thus, the noise characteristic can be improved. In particular, a most effective means for reducing the impedance at a high frequency is the full planarization. In recent years, the necessity of improvement in the noise characteristic has increased according to the higher speed, and increase in the consumption power of a semiconductor device.

According to an embodiment of the present invention, the wiring becomes fine and the margin of the wiring leading space is produced. Therefore, the marginal space can be allocated to the power supply line, and, thus, the power supply line can be fully planarized. An example of a power supply line 29a that is fully planarized is shown in FIG.10.

In FIG.10, reference numeral 23a, 23a,... denote the electrode terminals (power supply terminals) of the power supply for the semiconductor element 20. These power supply terminals 23a, 23a,... are connected by the line for the power supply (power supply line) 29a and also the power supply line 29a is formed as the full plane. Since the power supply line 29a is formed as the full plane, the noise characteristic of the semiconductor element 20 can be improved.

As described above, according to an embodiment of the present invention, the rerouting layer on the major surface on which the electrode terminals of the semiconductor element are provided is formed such that the wiring is formed thinner than the bonding pad. Since the wiring has a thin film thickness, the patterning precision of the wiring can be improved and fine wirings can be formed.

## Claims

1. A semiconductor device manufacturing method for forming a rerouting layer (30) on a major surface of a semiconductor element (20), where an electrode terminal (23) being provided on the major surface of the semiconductor element (20), and the rerouting layer (30) having a wiring (29) and a bonding pad (28) for electrically leading out the electrode terminal (23), the method comprising the step of:
forming the wiring (29) thinner than the bonding pad (28).

2. A semiconductor device manufacturing method for forming a rerouting layer (30) on a major surface of a semiconductor element (20), where an electrode terminal (23) being provided on the major surface of the semiconductor element (20), and the rerouting layer (30) having a wiring (29) and a bonding pad (28) for electrically leading out the electrode terminal (23), the method comprising the steps of:
forming a first conductive layer (22), which is electrically connected to the electrode terminal (23), on the major surface of the semiconductor element (20) ;
forming a second conductive layer (26) on a portion (24c) of the first conductive layer (24), where the portion (24c) acts as the bonding pad (28); and
forming the wiring (29) made of the first conductive layer (24), and the bonding pad (28) made by laminating the first conductive layer (24) and the second conductive layer (26), by patterning the first conductive layer (24).

3. A semiconductor device manufacturing method for forming a rerouting layer (30) on a major surface of a semiconductor element (20), where an electrode terminal (23) being provided on the major surface of the semiconductor element (20), and the rerouting layer (30) having a wiring (29) and a bonding pad (28) for electrically leading out the electrode terminal (23), the method comprising the steps of:
forming a first conductive layer (24), which is electrically connected to the electrode terminal (23), on the major surface of the semiconductor element (20);
forming the wiring (29) made of the first conductive layer (24) by patterning the first conductive layer (24), while leaving portion (24c) of the first conductive layer (24) where the portion (24c) acts as the bonding pad (28); and
forming the bonding pad (28) made by laminating the first conductive layer (24) and a second conductive layer (26) by forming the second conductive layer (26) on the portion (24c) of the first conductive layer (24).

4. A semiconductor device manufacturing method for forming a rerouting layer (30) on a major surface of a semiconductor element (20), where an electrode terminal (23) being provided on the major surface of the semiconductor element (20), and the rerouting layer (30) having a wiring (29) and a bonding pad (28) for electrically leading out the electrode terminal (23), the method comprising the steps of:
forming a masking layer (32) having an opening (32a), which has same shape as the wiring (29) and the bonding pad (28), on the major surface of the semiconductor element (20) ;
forming a first conductive layer (24), which is electrically connected to the electrode terminal (23), at least in the opening (32a) of the masking layer (32);
patterning the first conductive layer (24) by removing the masking layer (32); and
forming the bonding pad (28), which is made by laminating the first conductive layer (24) and a second conductive layer (26), by forming the second conductive layer (26) on a portion (24c) of the first conductive layer (24) where the portion (24c) acts as. the bonding pad (28), after the masking layer (32) is removed.

5. A semiconductor device manufacturing method for forming a rerouting layer (30) on a major surface of a semiconductor element (20), where an electrode terminal (23) being provided on the major surface of the semiconductor element (20), and the rerouting layer (30) having a wiring (29) and a bonding pad (28) for electrically leading out the electrode terminal (23), the method comprising the steps of :
forming a masking layer (32) having an opening (32a), which has same shapes as the wiring (29) and the bonding pad (28), on the major surface of the semiconductor element (20);
forming a first conductive layer (24), which is electrically connected to the electrode terminal (23), at least in the opening (32a) of the masking layer (32);
forming a second conductive layer (26) on a portion (24c) of the first conductive layer (24) where the portion (24c) acts as the bonding pad (28); and
forming the bonding pad (28), which is made by laminating the first conductive layer (24) and the second conductive layer (26), by patterning the first conductive layer (24) by removing the masking layer (32) after the second conductive layer (26) is formed.

6. A semiconductor device manufacturing method according to any one of claims 2 to 5, wherein the step of forming the first conductive layer (24) is executed by sputtering.

7. A semiconductor device manufacturing method according to claim 6, wherein the sputtering is carried out by sputtering any one of titanium (Ti) and chromium (Cr), and then sputtering copper (Cu).

8. A semiconductor device manufacturing method according to claim 7, wherein a semiconductor element (20), in which an insulating layer (22) made of any one of silicon nitride (SiN) or polyimide is formed on a major surface except a portion where the electrode terminal (23), is employed as the semiconductor element (20).

9. A semiconductor device manufacturing method according to any one of claims 2 to 8, wherein the step of forming the second conductive layer (26) is carried out by laminating a plurality of metal layers, and an uppermost layer (26c) of laminated films of the metal layers is formed of any one of gold (Au) and palladium (Pd).

10. A semiconductor device manufacturing method according to claim 9, wherein any one of copper (Cu)/nickel (Ni)/gold (Au) layers, titanium-tungsten (TiW)/gold (Au) layers, or nickel (Ni)/palladium (Pd) layers is employed as the laminated films of the metal layers.

11. A semiconductor device manufactured by the semiconductor device manufacturing method set forth in any one of claims 1 to 10.

12. A semiconductor device according to Claim 11, in which the semiconductor element (34) is bonded to a wiring substrate (38), and the bonding pad (28) of the rerouting layer (30) on the semiconductor element (34) and bonding pad (40) of the wiring substrate (38) are wire-bonded.

13. A semiconductor device according to claim 12, wherein another semiconductor element (35) is stacked on the semiconductor element (34), and an electrode terminal (23) of another semiconductor element (35) are electrically connected to the rerouting layer (30).

14. A semiconductor device comprising:
a semiconductor element (20) having an electrode terminal (23) on its major surface; and
a rerouting layer (30) formed on the major surface of the semiconductor element (20), where the rerouting layer (30) has a wiring (29) and a bonding pad (28) for electrically leading out the electrode terminal (23);
wherein the wiring (29) is thinner than the bonding pad (28).
